# EUROPEAN PATENT SPECIFICATION

(11) **EP 3 480 906 B1**
(45) Date of publication and mention of the grant of the patent: **27.05.2026**
(21) Application number: 18164911.2
(22) Date of filing: 29.03.2018
(51) Int. Cl.: H02B 1/56

(54) **ENCLOSURE OF ELECTRICAL COMPONENTS WITH A MODULAR VENTILATION SYSTEM**
GEHÄUSE MIT ELEKTRISCHEN KOMPONENTEN UND EINEM MODULAREN BELÜFTUNGSSYSTEMS
ENVELOPPE AVEC COMPOSANTS ÉLECTRIQUES ET SYSTÈME DE VENTILATION MODULAIRE

(30) Priority: 01.11.2017 IN 201741038827
(43) Date of publication of application: 08.05.2019
(73) Proprietor: Schneider Electric Industries SAS, 92500 Rueil-Malmaison (FR)
(72) Inventor: SINGH, Manish, 560087 Karnataka (IN); RAYKAR, Ganesh, 422023 Maharashtra (IN); JAIN, Akshay, 400607 Maharashtra (IN)
(74) Representative: Page White Farrer

(56) References cited:
- EP-A1- 2 256 884
- DE-A1- 19 847 454
- DE-U1- 29 601 769
- US-A1- 2006 012 954
- US-A1- 2007 115 630
- US-B2- 9 007 746

## Description

### TECHNICAL FIELD

The invention generally relates to a ventilation system. More particularly, the present invention relates to a ventilation system for air circulation. Furthermore particularly, the present invention relates to the ventilation system for an enclosure of electrical components.

### BACKGROUND

Switchgear enclosures are commonly employed in electrical power distribution systems for enclosing circuit breakers and other switching equipment associated with the distribution system. Typically, switchgear enclosures are comprised of a number of individual stacked or adjacent compartments, and receive electrical power from a power source and distribute is the electrical power through one or more feeder circuits to one or more loads. Switchgear enclosures typically include circuit protection device for interrupting electric power in a particular feeder circuit in response to hazardous current overloads in the circuit. A circuit protection device in electrical equipment can be a circuit breaker, fuse and switch combination, contactor and fuse combination or any other device intended to break or protect the load or secondary side of a circuit.

Switchgear is a general term covering switching and interrupting devices and their combination with associated control, instruments, metering, protective and regulating devices, and assemblies of these devices with associated interconnections, accessories, and supporting structures used primarily in connection with the generation, transmission, distribution, and conversion of electric power.

The standards for the specified temperature limits applicable to switchgear assemblies are defined globally. Further, the rated continuous current of metal-enclosed (ME) switchgear is the maximum current that can be carried continuously by the primary circuit components, including buses and connections, without producing a temperature in excess of specified limits for any primary or secondary circuit component, any insulating medium, or any structural or enclosing member.

Furthermore, the heat generated in the enclosure results in the derating of the circuit breakers in the switch gear panels, and results in failure of the entire system. Therefore, meeting the temperature limits in switchgear enclosures becomes more difficult as the current rating of the switchgear increases, and it becomes necessary to use air ventilation systems to maintain the required temperatures. Presently, the available systems (conduction and convection) do not provide the efficient inbuilt systems to prevent the system from breakdown due to heat, to maintain the temperature within the specified ranges inside the system and provide a sufficient ventilation system.

Furthermore, the performance of power gear and control gear assemblies (PSC) is determined and validated by temperature rise within the enclosure. Whenever conductor carries current, it generates heat. In enclosure heat gets dissipated through conduction and convection. There are maximum allowable temperature limits mentioned in standard. In higher rating enclosures heat dissipation through convection and conduction is not enough to maintain the maximum temperature within limit.

Accordingly, there is an unmet need to provide an improved ventilation system based on digital technology which overcomes the limitations of the prior art and is capable of effectively protecting electrical components in the enclosure having multiple electrical components.

The teachings herein extend to those embodiments which fall within the scope of the appended claims, regardless of whether they address one or more of the above-mentioned problems.
EP2256884 A1 discloses the preamble of claim 1 and describes an adapter device for housing a multi-phase low voltage type switch inside a switch-board. The adapter device is structured so as to define a connection area.
DE19847454 A1 describes an arrangement that has a fan with a control unit for controlling the fan, and a monitoring unit for monitoring the functionality of the fan. The fan, control unit and monitoring unit are combined into a single assembly. The ventilation unit is in the form of a flat, slide-in module.
US2007/115630 Al describes an electrical distribution apparatus configured to connect a load to a power source.
DE29601769 U1 describes a switchgear with heat-emitting components. US2006/012954 Al describes a network protector that includes a housing assembly, a circuit breaker, a control assembly and a convention cooling assembly.
US9007746 B2 describes a cabinet structure for a switchgear assembly. The cabinet structure includes a cabinet having upper and lower vents and a breaker cradle for holding a circuit breaker having primary disconnects for connecting the circuit breaker to bus bars.

### OBJECTS OF THE INVENTION

One object of the present invention is to provide an improved and a cost effective ventilation system.

Another object of the present invention is to provide a digital based ventilation system.

Yet another object of the invention is to provide an automated ventilation system to improve the effective ventilation in the electrical enclosure and providing a system with less maintenance cost.

Yet another object of the present invention is to provide a system for controlling the temperature inside the electrical enclosure.

Yet another object of the present invention is to provide a protection to the electrical components from failure due to heat.

Yet another object of the present invention is to provide a heat dissipation system in each of the phase housings in the electrical enclosure.

Yet another object of the present invention is to provide an automated fan based ventilation system.

Yet another object of the present invention is to provide a sensor based automated ventilation system for the enclosure having electrical components.

Yet another object of the invention is to detect a fault in the enclosure having electrical components.

Yet another object of the invention is to provide a system with higher electrical rating for the same configuration.

Yet another object of the invention is to detect a rise in temperature at a hottest point in the switchboard or the enclosure having electrical components, and trigger the system for heat dissipation through the ventilation system.

Yet another object of the invention is to provide a breakdown prevention system to raise an alarm based on heat detection in the ventilation system.

Yet another object of the invention to reduce the scalability overheads by increasing the heat dissipation capacity from the enclosure having electrical components.

Yet another object of the invention is to permit the pressure and hot gases to be released without the risk of injury to personnel who might be working near the switchgear.

These and other aspects as well as advantages will be more clearly understood from the following description taken in conjunction with the accompanying drawings.

### SUMMARY

An enclosure of electrical components is disclosed. According to the invention and as disclosed in claim 1, said enclosure of electrical components comprises a plurality of housing assemblies. Further, each of a housing assembly from the plurality of housing assemblies is a phase housing assembly. The enclosure of electrical components further comprising a terminal located at a first position in each of said plurality of said phase housing assemblies. Further, the terminal is a low resistant terminal. The enclosure of electrical components further comprising a ventilation system comprising a temperature controlling device for each of the terminals located at a second position. The second position is beneath the first position for ventilation. The first position is a maximum heat generation position in said phase housing assembly and the maximum heat generation position is a connection point of a bus bar and an air circuit breaker. The temperature controlling device is a fan unit which is operable based on a user defined trigger function. The user defined trigger function corresponds to a user defined temperature range. The user defined trigger function for each of said temperature controlling devices is an independent trigger function and corresponds to a different temperature range. The ventilation system comprises a breakdown prevention unit. When a temperature in said ventilation system goes beyond the user defined temperature range corresponding to the independent trigger function of each temperature controlling device, said breakdown prevention unit is configured to raise an alarm. Further embodiments are set forth in the dependent claims

### BRIEF DESCRIPTION OF THE ACCOMPANYING DRAWINGS

To further clarify advantages and aspects of the invention, a more particular description of the invention will be rendered by reference to specific embodiments thereof, which is illustrated in the appended drawings. It is appreciated that these drawings depict only typical embodiments of the invention and are therefore not to be considered limiting of its scope. The invention will be described and explained with additional specificity and detail with the accompanying drawings, which are listed below for quick reference.
**Figure 1** illustrates a block diagram of ventilation system, in accordance with the embodiment of the present invention,
**Figure 2** illustrates a system for breakdown prevention unit in the ventilation system, in accordance with the embodiment of the present invention,
**Figure 3** illustrates a set of housing assemblies in the electrical enclosure, in accordance with the embodiment of the present invention, and
**Figure 4** illustrates a hot spot in the housing assembly in the electrical enclosure, in accordance with the embodiment of the present invention.

It may be noted that to the extent possible, like reference numerals have been used to represent like elements in the drawings. Further, those of ordinary skill in the art will appreciate that elements in the drawings are illustrated for simplicity and may not have been necessarily drawn to scale. For example, the dimensions of some of the elements in the drawings may be exaggerated relative to other elements to help to improve understanding of aspects of the invention. Furthermore, the one or more elements may have been represented in the drawings by conventional symbols, and the drawings may show only those specific details that are pertinent to understanding the embodiments of the invention so as not to obscure the drawings with details that will be readily apparent to those of ordinary skill in the art having benefit of the description herein.

### DETAILED DESCRIPTION

It should be understood at the outset that although illustrative implementations of the embodiments of the present disclosure are illustrated below, the present invention may be implemented using any number of techniques, whether currently known or in existence.

The term "some" as used herein is defined as "none, or one, or more than one, or all." Accordingly, the terms "none," "one," "more than one," "more than one, but not all" or "all" would all fall under the definition of "some." The term "some embodiments" may refer to no embodiments or to one embodiment or to several embodiments or to all embodiments.

Accordingly, the term "some embodiments" is defined as meaning "no embodiment, or one embodiment, or more than one embodiment, or all embodiments."

More specifically, any terms used herein such as but not limited to "includes," "comprises," "has," "consists," and grammatical variants thereof do NOT specify an exact limitation or restriction and certainly do NOT exclude the possible addition of one or more features or elements, unless otherwise stated, and furthermore must NOT be taken to exclude the possible removal of one or more of the listed features and elements, unless otherwise stated with the limiting language "MUST comprise" or "NEEDS TO include."

Whether or not a certain feature or element was limited to being used only once, either way it may still be referred to as "one or more features" or "one or more elements" or "at least one feature" or "at least one element." Furthermore, the use of the terms "one or more" or "at least one" feature or element do NOT preclude there being none of that feature or element, unless otherwise specified by limiting language such as "there NEEDS to be one or more . . . " or "one or more element is REQUIRED."

Unless otherwise defined, all terms, and especially any technical and/or scientific terms, used herein may be taken to have the same meaning as commonly understood by one having an ordinary skill in the art.

Reference is made herein to some "embodiments." It should be understood that an embodiment is an example of a possible implementation of any features and/or elements presented in the attached claims. Some embodiments have been described for the purpose of illuminating one or more of the potential ways in which the specific features and/or elements of the attached claims fulfill the requirements of uniqueness, utility and non-obviousness.

The algorithms and displays presented herein are not inherently related to any particular computer or other apparatus. Various general-purpose systems may be used with programs in accordance with the teachings herein, or it may prove convenient to construct more specialized apparatus to perform the methods described herein. The structure for a variety of these systems is apparent from the description above. In addition, the exemplary embodiment is not described with reference to any particular programming language. It will be appreciated that a variety of programming languages may be used to implement the teachings of the exemplary embodiment as described herein.

A machine-readable medium (memory) includes any mechanism for storing or transmitting information in a form readable by a machine (e.g., a computer). For instance, a machine-readable medium includes read only memory ("ROM"); random access memory ("RAM"); magnetic disk storage media; optical storage media; flash memory devices; and electrical, optical, acoustical or other form of propagated signals (e.g., carrier waves, infrared signals, digital signals, etc.), just to mention a few examples.

Some portions of the detailed description herein are presented in terms of algorithms and symbolic representations of operations on data bits performed by conventional computer components, including a central processing unit (CPU), memory storage devices for the CPU, and connected display devices. These algorithmic descriptions and representations are the means used by those skilled in the data processing arts to most effectively convey the substance of their work to others skilled in the art. An algorithm is generally perceived as a self-consistent sequence of steps leading to a desired result. The steps are those requiring physical manipulations of physical quantities. Usually, though not necessarily, these quantities take the form of electrical or magnetic signals capable of being stored, transferred, combined, compared, and otherwise manipulated. It has proven convenient at times, principally for reasons of common usage, to refer to these signals as bits, values, elements, symbols, characters, terms, numbers, or the like.

It should be understood, however, that all of these and similar terms are to be associated with the appropriate physical quantities and are merely convenient labels applied to these quantities. Unless specifically stated otherwise, as apparent from the discussion herein, it is appreciated that throughout the description, discussions utilizing terms such as "processing" or "computing" or "calculating" or determining or "displaying" or the like, refer to the action and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

### DEFINITIONS

The following terms shall have, for the purposes of this application, the meanings set forth below.

An "enclosure for electrical components" corresponds to an enclosure having plurality of electrical components in the switchgear panel for the electrical power distribution. Further, the enclosure may constitute many other protection circuits. In an embodiment of the present invention, the enclosure for electrical components may comprise plurality of devices, such as but not limited to sensors, ventilation fan, wires, connectors, various other electrical circuits.

A "ventilation system" refers to an electronic device integrated with other sensors, fan unit, and electronic control unit. In an embodiment of the present invention, a ventilation system is an automated ventilation system. In an embodiment, when the temperature rises beyond a certain pre-defined temperature range, then the system automatically triggers the fan.

A "housing assembly" corresponds to a house for plurality of phase housing assemblies in the enclosure. In an embodiment of the present invention, each of the phase housing assembly has a low resistant terminal. In an embodiment, plurality of phase housing assemblies is connected to each other.

A "low resistant terminal" corresponds to a point in a phase housing assembly where the temperature or the heat may be maximum. In an embodiment, the low resistant terminal is also a connection point of a bus bar and an air circuit breaker where the maximum heat may be generated. In an embodiment, a fan is located below the low resistant terminal.

A "first position" corresponds to a position of terminal in the phase housing assembly. In an embodiment, the terminal is a low resistant terminal in the phase housing assembly.

A "second position" corresponds to a position below the first position in the phase housing assembly. In an embodiment of the present invention, a temperature controlling device is located at the second position.

A "temperature controlling device" corresponds to a fan unit. In an embodiment of the present invention, the fan unit gets triggered when the temperature at the low resistant terminal is above a pre-defined temperature range. Further, the temperature controlling device is protected by a breakdown protection unit which raises an alarm upon prediction of temperature rise in the system. In an embodiment, each of the temperature controlling devices may be operable individually.

"One or more sensors" refers to integrated sensors in the system configured to sense at least an absolute temperature value and a heat value. In an embodiment of the present invention, various other sensors such as smoke, fire, alarms may also be incorporated in the system for protection.

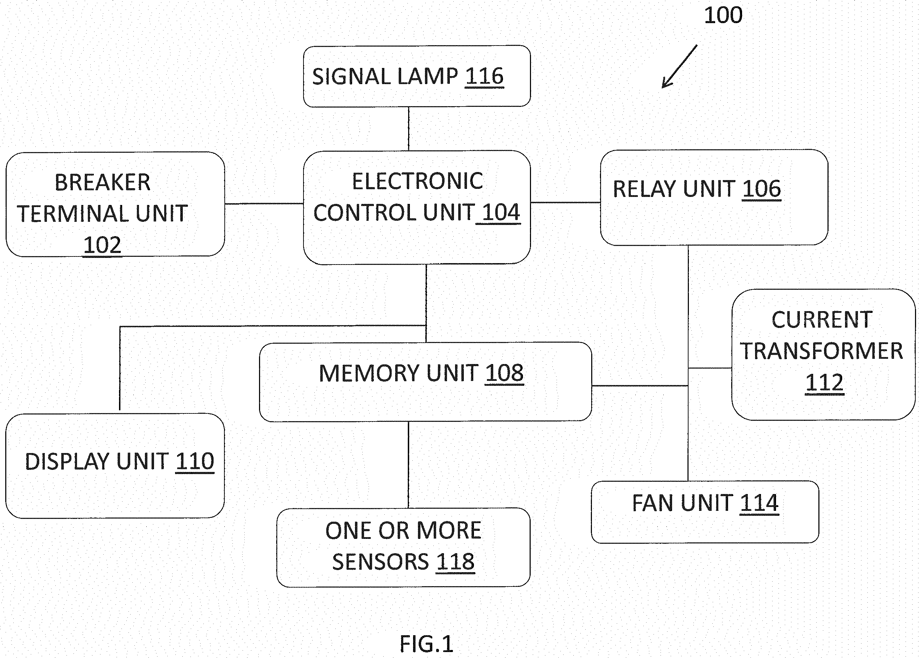

Figure 1 illustrates a block diagram of ventilation system 100, in accordance with the embodiment of the present invention,

In Figure 1, a block diagram of ventilation system 100 is shown. The ventilation system 100 comprises of a breaker terminal unit 102, an electronic control unit 104, a relay unit 106, a memory unit 108, a display unit 110, a current transformer 112, a fan unit 114, a signal lamp 116, and one or more sensors 118.

The breaker terminal unit 102 includes suitable logic, circuitry, and/or interfaces that are configured to break the circuit in case of detection of rise in temperature or failure of the fan unit 114. In an embodiment of the present invention, the breaker terminal unit 102 may be communicatively connected with the electronic control unit 104, the relay unit 106, the memory unit 108, the display unit 110, the current transformer 112, the fan unit 114, the signal lamp 116, and the one or more sensors 118.

The electronic control unit 104 includes suitable logic, circuitry, and/or interfaces that are configured to control the entire ventilation system. A plurality of microcontrollers may be integrated in the electronic control unit 104. Furthermore, the electronic control unit 104 may be communicatively coupled with the breaker terminal unit 102, the relay unit 106, the memory unit 108, the display unit 110, the current transformer 112, the fan unit 114, the signal lamp 116, and the one or more sensors 118.

In an embodiment of the present invention, the electronic control unit 104 may regulate the entire ventilation system and may further regulate the fan unit based on the temperature in the system.

The controller (not shown) may correspond to a microprocessor that is coupled to the plurality of ventilation modules through communication network. The controller includes suitable logic, circuitry, and/or interfaces that are operable to execute one or more instructions stored in the memory unit 210 to perform operations. The controller may be implemented using one or more processor technologies known in the art. Examples of the controller include, but are not limited to, an x86 microprocessor, a RISC microprocessor, an ASIC microprocessor, a CISC microprocessor, or any other microprocessor.

Furthermore, the controller (not shown) may be communicatively coupled with the breaker terminal unit 102, electronic control unit 104, the relay unit 106, the memory unit 108, the display unit 110, the current transformer 112, the fan unit 114, the signal lamp 116, and the one or more sensors 118. In an embodiment, the controller (not shown) may be integral part of the electronic control unit 104.

Further, in an embodiment, the controller may be capable of performing more than one operation in parallel. For example, the controller may be a multi-threaded processor, which may execute more than one process concurrently. Each such process may be executed to perform an operation, for e.g. controlling of the fan unit 114 by comparing the temperature generated due to heat and the temperature range stored in the micro controller by the user.

The relay unit 106 includes suitable circuitry that is configured to connect or disconnect the fan unit from the entire system. In an embodiment of the present invention. Furthermore, the relay unit 106 may be communicatively coupled with the breaker terminal unit 102, electronic control unit 104, the memory unit 108, the display unit 110, the current transformer 112, the fan unit 114, the signal lamp 116, and the one or more sensors 118.

The memory unit 108 includes suitable logic, circuitry, and/or interfaces that are operable to store the various readings. The memory unit 210 may be operable to store the one or more instructions. The memory unit 108 may store the time interval defined by the user to continuously monitor the temperature or heat value in the system to detect the fault. The various readings may correspond to the information, which may be utilized to protect the entire system. Further, the memory may correspond to a RAM type or a ROM type. Further, the memory unit may be communicatively attached to the rest of the electrical distribution system and collects the data from all sensors and other integrated devices in each of the fan units.

In an embodiment of the present invention, the memory unit 108 may transmit the information to remote servers at a pre-defined time interval, using communication medium, such as wireless communication medium. Further the memory unit 108 may also store data about the faults and the time stamp of the faults, number of times the fault has occurred and the alike.

The display unit 110 may comprise suitable logic, circuitry, interfaces, and/or code that may be operable to render a display. In an embodiment, the display device may be located at each of the fan units to display various readings and statics, such as current value, the leakage current value, fan speed, and various alarms etc. The display unit may have illumination for an easy display of plurality of readings.

The display unit 110 may be further integrated with the communication network to communicate the data to the remotely located servers. Furthermore, the display unit 110 may be communicatively coupled with the breaker terminal unit 102, electronic control unit 104, relay unit 106, the memory unit 108, the current transformer 112, the fan unit 114, the signal lamp 116, and the one or more sensors 118. In an embodiment, the display unit 110 may be a touch panel which may enable the user to configure the range of temperature for each of the fan units 114 in the enclosure.

The current transformer 112 may be configured to measure value of a current flowing in the enclosure. Furthermore, the current transformer 112 may be a current sensing unit of the power system. Current transformers are used at generating stations, electrical substations, and in industrial and commercial electric power distribution.

In an embodiment of the present invention, the current transformer 112 may include a primary winding, a core, and a secondary winding (not shown).

The fan unit 114 may be configured to exhaust the heat generated in the system. In an embodiment of the present invention, the fan unit 114 may be an automated digital operable fan unit 114. In an embodiment of the present invention, a plurality of fan units, each located at the hot spot below ACB terminal, may be configured to run at different speeds.

In an embodiment of the present invention, the fan unit 114 may be controlled by the controller. The controller may be connected with the ON/OFF mechanism of the fan unit 114. Furthermore, the relay unit 106 along with the one or more sensors 118 may control the regulation of the fan unit 114.

In an embodiment of the present invention, all the fan units in the enclosure may run simultaneously based on the detection of rise in temperature by the one or more sensors. Alternatively, the fan units may be functional based on the demand of the user or one or more user defined parameters, such as but not limited to a user defined time interval for each of the fan unit in the enclosure or a fixed time stamp to ON each of the fan unit in the enclosure.

The signal lamp 116 may be configured to blown up in case of any system failure. In an embodiment, when the heat or temperature goes beyond specified limit in the enclosure, then the signal lamp may lighten up and reflects the error to the user. Furthermore, in an alternate embodiment, the signal lamp 116 may get lighten up when the system may be in proper working mode and no error may be detected.

**The** one or more sensors 118 may comprise suitable logic, circuitry, interfaces, and/or code that may be operable to sense at least the temperature at the hot spot. In an embodiment of the present invention, a thermal sensor may be mounted on the hot spot of the switchgear and the bus bar. The sensor may be configured to measure an absolute temperature of the hot spot, and further to send the signal to the micro controller.

In an embodiment of the present invention, the communication network may include connections such as wire, wireless communication links, or fiber optic cables. The communication network (not shown) may also be implemented using WLAN, Bluetooth or any other communication technology. The communication network may employ any network topology, transmission medium, or network protocol.

In an embodiment of the present invention, the user may control (trigger function) the fan units 114 from a remote location through a wireless communication channel. Furthermore, the speed of the fan unit 114 may be dynamically regulated by the user based on the requirement of the heat generation in the system.

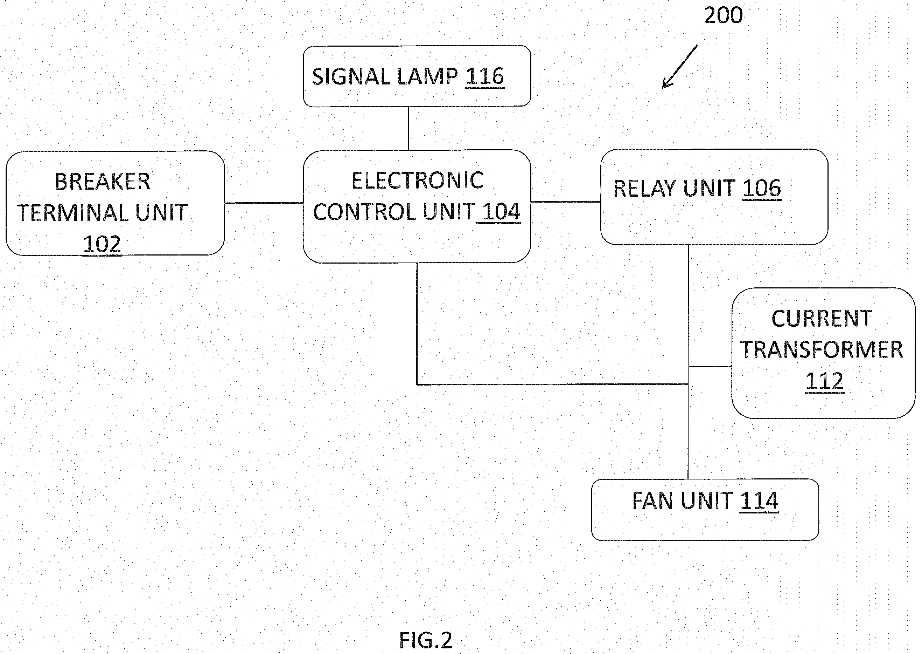

**Figure 2** illustrates a system for breakdown prevention unit in the ventilation system, in accordance with the embodiment of the present invention.

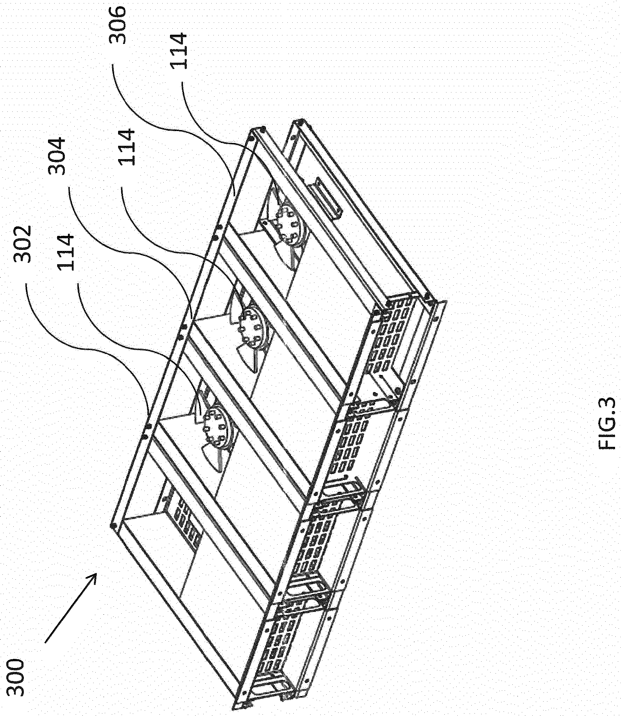

As illustrated in figure 200, the output of thermal sensor (not shown) may be connected to the input of microprocessor based controller (integrated in the electronic control unit 104) which in turn takes the decision to switch ON or OFF the fans by use of relay unit 106. The micro controller may be configured with an allowable maximum temperature at given point of temperature measurement. Thereafter, the output of micro controller may be connected to each fan unit 302a, 302b, and 302c (as shown in figure 3) for its ON-OFF control. In an embodiment, each of the ON-OFF control of the fan units may be configured to operate at different temperatures.

In an exemplary embodiment, sensors may be connected to ACB terminals of R, Y and B phase (not shown) and further connected to the micro controller. Each output of controller is configured to operate at different temperature. O/P-1 at 80°C, O/P-2 at 85°C and O/P-3 at 90°C. When temperature reaches to 80°C, O/P-1 relay may get activate and switch ON Fan-A. If temperature still rises beyond and reaches to 85°C, O/P-2 relay may get activated and switch ON fan-B. Furthermore, the temperature still rising beyond and reaches 90°C, O/P-3 will switch ON Fan-C. Thereafter, in an embodiment, if the problem still persists and temperature rising beyond 90°C, O/P-4 may actuate alarm/ mounted on the panel in the enclosure.

In an embodiment the micro controller in each of the ventilation module may be configured based on a location, such that a cut off temperature of fan in the ventilation module A may be different from the cut off temperature of fan in the ventilation module B or C having fan units 302a, 302b, and 302c.

A person skilled in the art will understand that the scope of the disclosure should not be limited to the above-mentioned number of ventilation modules or fan units. The number of ventilation modules o the fan units may be based on plurality of factors such as but not limited to the capacity of the entire system.

**Figure 3** illustrates a set of housing assemblies in the electrical enclosure, in accordance with the embodiment of the present invention.

As illustrated in figure 300 a set of housing assemblies in the electrical enclosure are shown.

There is shown a housing assembly 302 for R phase. In an embodiment of the present invention, each of the phase housing assembly includes ventilation module for ventilation, which includes at least a fan unit 114, microprocessor based controller (not shown) and mounting arrangement. Further, the mounting arrangement is placed below the R Terminal of Circuit breaker. The Module is placed in such a way that the fan unit 114 is below the hottest point, and the module may be inserted from front and then screwed to the casing which holds the module in its place.

There is shown a housing assembly 304 for Y phase. In an embodiment of the present invention, each of the phase housing assembly includes ventilation module for ventilation, which includes at least a fan unit 114, microprocessor based controller and mounting arrangement. Further, the mounting arrangement is placed below the Y Terminal of Circuit breaker. The Module is placed in such a way that the fan unit 114 is below the hottest point, and the module may be inserted from front and then screwed to the casing which holds the module in its place.

There is shown a housing assembly 306 for B phase. In an embodiment of the present invention, each of the phase housing assembly includes ventilation module for ventilation, which includes at least a fan unit 114, microprocessor based controller and mounting arrangement. Further, the mounting arrangement is placed below the B Terminal of Circuit breaker. The Module is placed in such a way that the fan unit 114 is below the hottest point, and the module may be inserted from front and then screwed to the casing which holds the module in its place.

In an embodiment, the above mentioned housing assemblies (302, 304, and 306) may be interconnected with each other for current flow in the system. In an embodiment, in case of failure of one housing assembly, the connection may be altered in such a manner that the system may bypass the current from the failed housing assembly and rest of the system may remain in operational condition.

In an embodiment, the fan units 114 may direct cool air sucked through louvers provided on surface of the enclosure to the ACB terminal (hot spot), and the hot air coming from the hot spot may be released to the external environment through ventilation roof and louvers provided on the top of the enclosure.

According to the invention, the temperature controlling device 114 is operable based on a user defined trigger function. Further, the trigger function corresponds to a defined temperature range by the user to operate the fan unit 114. Each of the fan unit 114 have a different operable temperature range. Further, the user may define the second position based on the heat generation in the system. The second position corresponds to the position of the fan units 114.

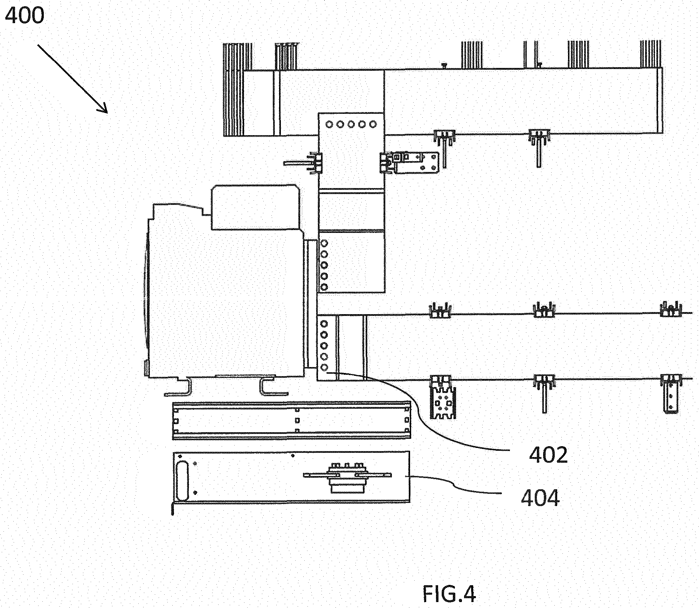

**Figure 4** illustrates a hot spot in the housing assembly in the electrical enclosure, in accordance with the embodiment of the present invention.

As shown in figure 400, there is shown a hot spot 402. The hot spot 402 corresponds to a point of intersection of terminal of air circuit breaker and the bus bars. In an embodiment of the present invention the current is passed in the air circuit breaker at the point of intersection. Furthermore, the space at the point of intersection is very low, therefore maximum heat is generated at this point. The fan unit 114 as discussed in figure 3 is placed below these hot spots 402.

In an embodiment of the present invention, one or more sensors 118 may be mounted on identified hot spot 402 of the switchgear and busbar. These one or more sensors 118 may be configured to measure the absolute temperature of the hot spot and send signal to micro controller. These one or more sensors 118 may be suitable operate efficiently up to 150°C. Further, in an embodiment, a thermal monitoring device is attached to the terminals of circuit breaker and connected to a plug 404 mounted on the ventilation module. In an embodiment, when the module is moved inside then the plug 404 makes the connection.

In an exemplary embodiment, a power distribution enclosure may constitute three fan units that are configured to regulate the heat inside the enclosure. The user may define the range of temperature for each of the fan unit in the micro controller associated with each of the fan unit. Further temperature sensors may be mounted on a hot spot which is an intersection point of switch gear and bus bars in the enclosure. These temperature sensors may be configured to measure an absolute temperature of the hot spot in the enclosure and thereafter sends the signals to the micro controller. Further, the micro controller determines the action to ON/OFF the fan unit based on the user defined temperature range. When the micro controller determines that the temperature of any fan unit goes beyond the defined temperature range, then it actuates the fan in ON mode and continuously monitors the change in the temperature. In case, the temperature still rises beyond the specified limits of the other fan units, then it actuates other fan units as well. Lastly, in case of further rise in temperature, the micro controller actuates the alarms, and closes the entire system. This enables the user to protect the fan units from failure and thereafter, the micro controller sends the failure signal to the display device associated with the system.

## Claims

1. An enclosure of electrical components, said enclosure of electrical components comprising:
a plurality of housing assemblies (302,304,306), wherein each of a housing assembly from said plurality of housing assemblies is a phase housing assembly;
a terminal (402) located at a first position in each of said plurality of said phase housing assemblies, wherein said terminal is a low resistant terminal; and
a ventilation system (100) comprising a temperature controlling device (114) for each of said terminals (402) located at a second position, wherein said second position is beneath said first position for ventilation;
wherein said first position is a maximum heat generation position in said phase housing assembly and wherein said maximum heat generation position is a connection point of a bus bar and an air circuit breaker;
wherein said temperature controlling device is a fan unit (114) which is operable based on a user defined trigger function, wherein the user defined trigger function corresponds to a user defined temperature range; and
**characterized in that** the user defined trigger function for each of said temperature controlling devices is an independent trigger function and corresponds to a different temperature range;
and **in that** said ventilation system (100) comprises a breakdown prevention unit, wherein when a temperature in said ventilation system (100) goes beyond the user defined temperature range corresponding to the independent trigger function of each temperature controlling device (114), said breakdown prevention unit is configured to raise an alarm.

2. The enclosure of electrical components as claimed in claim 1, wherein each of said phase housing assembly in said plurality of housing assemblies (302, 304, 306) are connected to other phase housing assemblies for current flow.

3. The enclosure of electrical components as claimed in claim 1, wherein the ventilation system (100) comprises of one or more sensors (118) configured to sense at least an absolute temperature value and a heat value.

4. The enclosure of electrical components as claimed in claim 1, wherein the ventilation system (100) comprises of a display unit (110) configured to display a plurality of readings in said ventilation system (100).

5. The enclosure of electrical components as claimed in claim 1, wherein a distance between the second position and said first position for ventilation is a user defined distance.

6. The enclosure of electrical components as claimed in claim 1, wherein the ventilation system (100) comprises a relay unit (106) to operate said temperature controlling device.

## Patentansprüche

1. Hülle für elektrische Komponenten, die Hülle für elektrische Komponenten umfassend:
eine Vielzahl von Gehäusebaugruppen (302, 304, 306), wobei jede der Gehäusebaugruppen aus der Vielzahl von Gehäusebaugruppen eine Phasengehäusebaugruppe ist;
einen Anschluss (402), der sich an einer ersten Position in jeder der Vielzahl der Phasengehäusebaugruppen befindet, wobei der Anschluss ein wenig widerstandsfähiger Anschluss ist; und
ein Belüftungssystem (100), umfassend eine Temperatursteuerungsvorrichtung (114) für jedes der Anschlüsse (402), die sich an einer zweiten Position befinden, wobei die zweite Position unterhalb der ersten Position zur Belüftung liegt;
wobei die erste Position eine Position maximaler Wärmeerzeugung in der Phasengehäusebaugruppe ist und wobei die Position maximaler Wärmeerzeugung ein Verbindungspunkt einer Sammelschiene und eines Luftleistungsschalters ist;
wobei die Temperatursteuerungsvorrichtung eine Lüftereinheit (114) ist, die basierend auf einer benutzerdefinierten Auslösefunktion betreibbar ist, wobei die benutzerdefinierte Auslösefunktion einem benutzerdefinierten Temperaturbereich entspricht; und
**dadurch gekennzeichnet, dass** die vom Benutzer definierte Auslösefunktion für jede der Temperatursteuerungsvorrichtungen eine unabhängige Auslösefunktion ist und einem anderen Temperaturbereich entspricht;
und dadurch, dass
das Belüftungssystem (100) eine Ausfallverhinderungseinheit umfasst,
wobei die Ausfallverhinderungseinheit konfiguriert ist, um einen Alarm auszulösen, wenn eine Temperatur in dem Belüftungssystem (100) den benutzerdefinierten Temperaturbereich überschreitet, der der unabhängigen Auslösefunktion jeder Temperatursteuerungsvorrichtung (114) entspricht.

2. Hülle für elektrische Komponenten nach Anspruch 1, wobei jede der Phasengehäusebaugruppen in der Vielzahl von Gehäusebaugruppen (302, 304, 306) mit anderen Phasengehäusebaugruppen für den Stromfluss verbunden ist.

3. Hülle für elektrische Komponenten nach Anspruch 1, wobei das Belüftungssystem (100) einen oder mehrere Sensoren (118) umfasst, die konfiguriert sind, um mindestens einen absoluten Temperaturwert und einen Wärmewert zu erfassen.

4. Hülle für elektrische Komponenten nach Anspruch 1, wobei das Belüftungssystem (100) eine Anzeigeeinheit (110) umfasst, die konfiguriert ist, um eine Vielzahl von Lesungen in dem Belüftungssystem (100) anzuzeigen.

5. Hülle für elektrische Komponenten nach Anspruch 1, wobei ein Abstand zwischen der zweiten Position und der ersten Position zur Belüftung ein vom Benutzer definierter Abstand ist.

6. Hülle für elektrische Komponenten nach Anspruch 1, wobei das Belüftungssystem (100) eine Relaiseinheit (106) zum Betreiben der Temperatursteuerungsvorrichtung umfasst.

## Revendications

1. Coffret de composants électriques, ledit coffret de composants électriques comprenant :
une pluralité d'ensembles boîtiers (302, 304, 306), dans lequel chacun d'un ensemble boîtier parmi ladite pluralité d'ensembles boîtiers est un ensemble boîtier de phase ;
une borne (402) située à une première position dans chacun de ladite pluralité desdits ensembles boîtiers de phase, dans lequel ladite borne est une borne à faible résistance ; et
un système de ventilation (100) comprenant un dispositif de régulation de température (114) pour chacune desdites bornes (402) situées à une seconde position, dans lequel ladite seconde position se trouve en dessous de ladite première position de ventilation ;
dans lequel ladite première position est une position de génération maximale de chaleur dans ledit ensemble boîtier de phase et dans lequel ladite position de génération maximale de chaleur est un point de connexion entre une barre omnibus et un disjoncteur à air ;
dans lequel ledit dispositif de régulation de température est une unité de ventilation (114) qui fonctionne sur la base d'une fonction de déclenchement définie par l'utilisateur, dans lequel la fonction de déclenchement définie par l'utilisateur correspond à une plage de température définie par l'utilisateur ; et
**caractérisé en ce que** la fonction de déclenchement définie par l'utilisateur pour chacun desdits dispositifs de régulation de température est une fonction de déclenchement indépendante et correspond à une plage de température différente ;
et **en ce que**
ledit système de ventilation (100) comprend une unité de prévention des pannes, dans lequel lorsqu'une température dans ledit système de ventilation (100) dépasse la plage de température définie par l'utilisateur correspondant à la fonction de déclenchement indépendante de chaque dispositif de régulation de température (114), ladite unité de prévention des pannes est configurée pour déclencher une alarme.

2. Coffret de composants électriques selon la revendication 1, dans lequel chacun dudit ensemble boîtier de phase dans ladite pluralité d'ensembles boîtiers (302, 304, 306) est connecté à d'autres ensembles boîtiers de phase pour permettre la circulation du courant.

3. Coffret de composants électriques selon la revendication 1, dans lequel le système de ventilation (100) est composé d'un ou plusieurs capteurs (118) configurés pour détecter au moins une valeur de température absolue et une valeur de chaleur.

4. Coffret de composants électriques selon la revendication 1, dans lequel le système de ventilation (100) est composé d'une unité d'affichage (110) configurée pour afficher une pluralité de valeurs de mesure dans ledit système de ventilation (100).

5. Coffret de composants électriques selon la revendication 1, dans lequel une distance entre la seconde position et ladite première position de ventilation est une distance définie par l'utilisateur.

6. Coffret de composants électriques selon la revendication 1, dans lequel le système de ventilation (100) comprend une unité de relais (106) destinée à commander ledit dispositif de régulation de température.
